# EUROPÄISCHE PATENTSCHRIFT

(11) **EP 2 760 045 B1**
(45) Veröffentlichungstag und Bekanntmachung des Hinweises auf die Patenterteilung: **18.09.2019**
(21) Anmeldenummer: 14152065.0
(22) Anmeldetag: 22.01.2014
(51) Int. Cl.: H01L 23/498

(54) **Elastomerprodukt**
Elastomer product
Produit élastomère

(30) Priorität: 28.01.2013 DE 202013000810 U
(43) Veröffentlichungstag der Anmeldung: 30.07.2014
(73) Patentinhaber: ASTRA Gesellschaft für Asset Management mbH & Co. KG, 30890 Barsinghausen (DE)
(72) Erfinder: Stobbe, Anatoli, 30890 Barsinghausen (DE); Maaß, Norman, 30455 Hannover (DE)
(74) Vertreter: Patentanwälte Thömen & Körner

(56) Entgegenhaltungen:
- WO-A1-03/105511
- WO-A1-2006/029543
- WO-A2-2005/071605
- DE-A1-102005 008 397
- JP-A- 2003 108 964
- US-A1- 2006 012 482
- US-A1- 2008 012 709

## Beschreibung

Die Erfindung betrifft ein Elastomerprodukt nach dem Oberbegriff des Anspruchs 1.

Elastomerprodukte werden in der verarbeitenden Industrie, z. B. Förderbänder, Kupplungen, im Fahrzeugbau, z. B. Reifen, im Handel, z. B. Matten, in der Medizintechnik sowie im privaten Bereich verwendet. Ist es erforderlich, physikalische Angaben, wie Temperatur, Dehnung, Alter oder wirtschaftliche Angaben, wie Hersteller, Eigentümer, Art, Anzahl der Verwendung sowie der Reinigung der Elastomerprodukte zu erfassen und für eine Abfrage bereitzustellen, so eignen sich hierfür elektronische Sensoren und/oder Datenspeicher, die im Idealfall kontaktlos gelesen und gegebenenfalls auch kontaktlos beschrieben werden können. Zur eindeutigen Zuordnung der Daten zum Elastomerprodukt ist eine möglichst untrennbare Verbindung zwischen den Sensoren und/oder dem Datenspeicher anzustreben.

Aus der DE 10 2010 016 359 A1 ist ein Elastomerprodukt mit einer in einen elastomeren Werkstoff eingebetteten und von diesem umschlossenen elektronischen Schaltung bekannt.

Als Träger der elektronischen Schaltung dient eine dünne Folie, auf der Leiterbahnen und ein Transponder angeordnet sind. Im Bereich des Trägers haben die an den Träger angrenzenden Schichten des elastomeren Werkstoffs untereinander keinerlei Verbindung. Allenfalls besteht eine Verbindung zwischen den Schichten des elastomeren Werkstoffs und dem Träger selbst, was in der mechanischen Festigkeit allerdings einer direkten Verbindung der Schichten nachsteht.

Es besteht daher die Gefahr, dass die Leiterbahnen und der Transponder nicht mehr durch den elastomeren Werkstoff fixiert werden und bei mechanischen Beanspruchungen Unterbrechungen der Kontakte eintreten können. Weiterhin können die an den Träger angrenzenden Schichten des elastomeren Werkstoffs abschälen und es kann sich ein Abschälspalt in den umgebenden elastomeren Werkstoff ausbreiten.

Aus der JP 2003108964 A ist ein Elastomerprodukt mit einer in einen elastomeren Werkstoff eingebetteten und von diesem umschlossenen elektronischen Baugruppe bekannt. Die elektronische Baugruppe umfasst ein Chipmodul aus einem Träger mit einem eine integrierte elektronische Schaltung enthaltenden Chip und einen Antennenleiter. Der Antennenleiter befindet sich unmittelbar im elastomeren Werkstoff.

Außerdem ist aus der WO 03/105511 A1 ein Elastomerprodukt mit einer oder mehreren in einen elastomeren Werkstoff eingebetteten und von diesem umschlossenen elektronischen Baugruppe(n) bekannt. Die elektronische Baugruppe umfasst ein Chipmodul aus einem Träger mit einem eine integrierte elektronische Schaltung enthaltenden Chip und einem Antennenleiter.

Der Erfindung liegt die Aufgabe zugrunde, ein Elastomerprodukt mit einer in einen elastomeren Werkstoff eingebetteten und von diesem umschlossenen elektronischen Baugruppe zu schaffen, bei dem im bestimmungsgemäßen Einsatzfall sowohl die elastomeren Eigenschaften des Elastomerprodukts als auch die Funktionsfähigkeit der elektronischen Baugruppe erhalten bleiben.

Diese Aufgabe wird bei einem Elastomerprodukt nach dem Oberbegriff des Anspruchs 1 durch die Merkmale dieses Anspruchs gelöst.

Weiterbildungen und vorteilhafte Ausgestaltungen ergeben sich aus den Unteransprüchen.

Durch die bauliche Trennung des Chipmoduls vom Antennenmodul und die induktive Kopplung werden zwei unabhängige Einheiten geschaffen, die auch bei mechanischen Belastungen und daraus resultierenden geringfügigen gegenseitigen Versetzungen eigenständig sind, aber trotzdem in Interaktion bleiben und so die Gesamtfunktion zuverlässig sicherstellen. Außerdem ist der zweite Träger ein biegsames Flächengebilde aus Gaze, wobei die Gaze textile, elektrisch nichtleitende Fäden oder Fasern umfasst, die nach Art eines Gitters angeordnet sind, und fäden- oder faserfreie Zwischenräume enthalten und dass diese Zwischenräume von dem elastomeren Werkstoff durchsetzt sind und die an die Flachseiten des zweiten Trägers angrenzenden Flächen des elastomeren Werkstoffs untereinander durch die Gaze hindurch verbinden.

Durch diesen Aufbau werden die an den zweiten Träger angrenzenden Schichten des elastomeren Werkstoffs nicht voneinander getrennt, sondern vielmehr durch die Zwischenräume der Gaze durchgehende Stege aus elastomeren Werkstoff untereinander verbunden. Ein Abschälen wird so verhindert.

Der Antennenleiter kann einen flexiblen Draht oder textile, elektrisch leitfähige Fäden oder Fasern umfassen, die mittels elektrisch nichtleitenden textilen Stickgarns durch textile Sticktechnik an den Fäden oder Fasern der Gaze befestigt sind.

Der Antennenleiter kann so mit hoher Wiederholbarkeit entsprechend einer vorgegebenen Struktur verlegt und fixiert werden. Durch die Verbindung mit der Gaze werden die Positionen des Antennenleiters beim Herstellungsprozess und bei der Verwendung des Elastomerprodukts bewahrt.

Alternativ kann der Antennenleiter einen flexiblen Draht oder textile, elektrisch leitfähige Fäden oder Fasern umfassen, die weitere Bestandteile der Gaze selbst sind.

Mit dieser Ausführung bietet eine noch gesteigerte Wiederholbarkeit und verringert eine Loslösung des Antennenleiters von der vorgegebenen Struktur.

Das Chipmodul kann mittels einer flächigen über die Fläche des Chipmoduls selbst hinausgehenden Abdeckung, die an der Gaze durch eine thermoplastische Verbindung befestigt ist, zwischen der Gaze und der flächigen Abdeckung fixiert sein.

Gegenüber einer Verbindung des Chipmoduls mit seiner eigenen Fläche bietet diese Verbindungsart ein größere Verbindungsfläche und damit eine bessere und gegen ungewollte Verlagerungen sichere Positionierung gegenüber dem Antennenmodul.

Vorzugsweise ist der Antennenleiter ein mechanisch verkürzter aber auf eine vorgegebene Resonanzfrequenz elektrisch verlängerter Dipol, der in einer Koppelzone zu einer der Form der Koppelschleife des Chipmoduls folgender Windung geformt ist und dessen Strahlerelemente sich in Strahlerzonen außerhalb der Koppelzone zunächst in gegensätzliche Richtung erstrecken und anschließend jeweils wenigstens einmal abknicken.

Gegenüber einem gestreckten Dipol wird durch diese Maßnahme der magnetische Anteil der elektromagnetischen Wellen im Nahfeld erhöht. Die Antenne wird so unempfindlicher gegen Verstimmungen der Resonanzfrequenz durch in der Nähe befindliche andere leitfähige Materialien, die in dem elastomeren Werkstoff angeordnet sein können, zum Beispiel Russ. Außerdem wird die Richtcharakteristik der Antenne zu Gunsten einer besseren Rundstrahlung verändert.

Nachfolgend wird die Erfindung anhand von Ausführungsbeispielen in der Zeichnung erläutert. Darin zeigen:
Fig. 1 eine schematische Draufsicht auf ein Antennenmodul in einer ersten Ausführung,
Fig. 2 einen schematischen Querschnitt durch das in Figur 1 dargestellte, in einen elastomeren Werkstoff eingebettetes Antennenmodul und
Fig. 3 eine schematische Draufsicht auf ein Antennenmodul in einer 2. Ausführung.

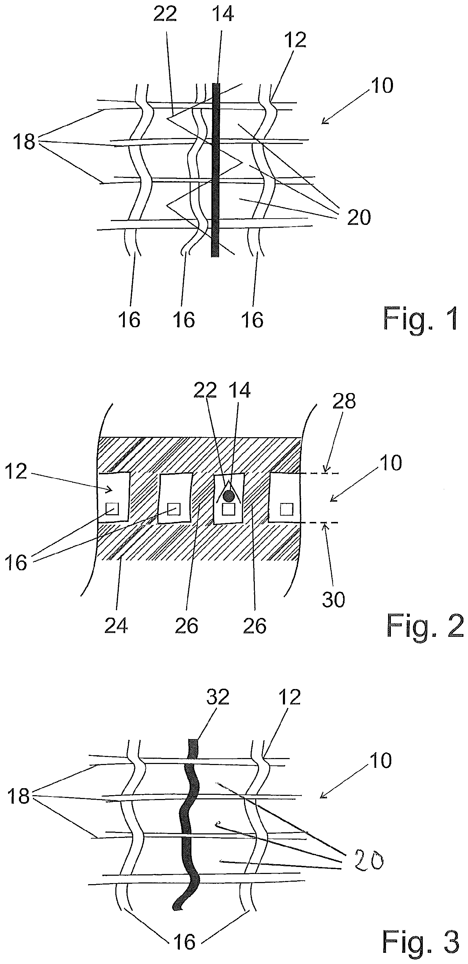

In Fig. 1 ist eine schematische Draufsicht auf ein Antennenmodul 10 in einer ersten Ausführung dargestellt. Das Antennenmodul 10 ist Bestandteil einer elektronische Baugruppe, die ein hier nicht dargestelltes Chipmodul aus einem ersten Träger mit einem eine integrierte elektronische Schaltung enthaltenden Chip und einer mit dem Chip verbundenen induktiven Koppelschleife und das Antennenmodul 10 aus einem zweiten Träger und einem Antennenleiter umfasst. Dabei ist das Chipmodul auf dem Antennenmodul angeordnet und die Koppelschleife induktiv mit dem Antennenleiter gekoppelt.

Das Antennenmodul 10 besteht aus einem biegsamen Flächengebilde aus Gaze 12 mit einem Antennenleiter 14. Die Gaze 12 umfasst textile, elektrisch nichtleitende Fäden oder Fasern, die nach Art eines Gitters angeordnet sind und bei einem Gewebe Schussfäden 16 und Kettfäden 18 darstellen, und fäden- oder faserfreie Zwischenräume 20 enthalten. Der Antennenleiter 14 umfasst einen flexiblen Draht oder textile, elektrisch leitfähige Fäden oder Fasern. Diese sind mittels elektrisch nichtleitenden textilen Stickgarns 22 durch textile Sticktechnik an den Fäden oder Fasern 16, 18 der Gaze 12 befestigt.

Fig. 2 zeigt einen schematischen Querschnitt durch das in Figur 1 dargestellte, in einen elastomeren Werkstoff 24 eingebettetes Antennenmodul 10. Das Antennenmodul 10 ist von dem elastomeren Werkstoff 24 vollständig umschlossen. Oberhalb und unterhalb des Antennenmoduls 10 grenzen Flächen 28, 30 aus elastomerem Werkstoff 24an die Flachseiten des Trägers, nämlich der Gaze 12 des Antennenmoduls 10 an. Die fäden- oder faserfreien Zwischenräume 20 der Gaze 12 sind von dem elastomeren Werkstoff als Verbindungsstege 26 durchsetzt und verbinden die an die Flachseiten des zweiten Trägers angrenzenden Flächen 28, 30 des elastomeren Werkstoffs 24 untereinander durch die Gaze 12 hindurch. Dadurch werden die Flächen 28, 30 des elastomeren Werkstoffs 24 formschlüssig fixiert und daran gehindert, bei mechanischen Beanspruchungen, wie Biegen oder Stauchen, voneinander abzuheben.

Fig. 3 zeigt eine schematische Draufsicht auf ein Antennenmodul 10 in einer 2. Ausführung. Wiederum besteht das Antennenmodul 10 aus einem biegsamen Flächengebilde aus Gaze 12 mit einem Antennenleiter 32. Auch die Gaze 12 umfasst textile, elektrisch nichtleitende Fäden oder Fasern 16, 18, die nach Art eines Gitters angeordnet sind, und fäden- oder faserfreie Zwischenräume 20 enthalten. In diesem Ausführungsbeispiel ist der Antennenleiter 32 aber nicht aufgestickt, sondern umfasst textile, elektrisch leitfähige Fäden oder Fasern, die weitere Bestandteile der Gaze 12 selbst sind. Analog zu der Ausführung nach Fig. 1 ist auch die Ausführung nach Fig. 3 in einen elastomeren Werkstoff 24 eingebettet und von diesem vollständig umschlossen. Bis auf die abweichende Ausgestaltung des Antennenleiters 32 ergibt sich ein Querschnittaufbau analog zu Fig. 2.

## Patentansprüche

1. Elastomerprodukt mit einer in einen elastomeren Werkstoff (24) eingebetteten und von diesem umschlossenen elektronischen Baugruppe, die ein Chipmodul aus einem ersten Träger mit einem eine integrierte elektronische Schaltung enthaltenden Chip umfasst, sowie einem Antennenleiter (14, 32) **dadurch gekennzeichnet, dass** die elektronische Baugruppe als weiteren Bestandteil des Chipmoduls aus dem ersten Träger mit dem die integrierte elektronische Schaltung enthaltenden Chip ferner eine mit dem Chip verbundene induktive Koppelschleife und ein Antennenmodul (10) aus einem zweiten Träger und dem Antennenleiter umfasst, wobei das Chipmodul in oder auf dem Antennenmodul angeordnet ist und die Koppelschleife induktiv mit dem Antennenleiter gekoppelt ist, der zweite Träger ein biegsames Flächengebilde aus Gaze (12) ist, die Gaze textile, elektrisch nichtleitende Fäden oder Fasern (16,18) umfasst, die nach Art eines Gitters angeordnet sind, und fäden- oder faserfreie Zwischenräume (20) enthalten und dass diese Zwischenräume von dem elastomeren Werkstoff durchsetzt sind und die an die Flachseiten des zweiten Trägers angrenzenden Flächen (28, 30) des elastomeren Werkstoffs untereinander durch die Gaze hindurch verbinden.

2. Elastomerprodukt nach Anspruch 1, **dadurch gekennzeichnet, dass** der Antennenleiter einen flexiblen Draht oder flextile, elektrisch leitfähige Fäden oder Fasern umfasst, die mittels elektrisch nichtleitenden textilen Stickgarns durch textile Sticktechnik an den Fäden oder Fasern der Gaze befestigt sind.

3. Elastomerprodukt nach Anspruch 1, **dadurch gekennzeichnet, dass** der Antennenleiter einen flexiblen Draht oder textile, elektrisch leitfähige Fäden oder Fasern umfasst, die weitere Bestandteile der Gaze selbst sind.

4. Elastomerprodukt nach einem der Ansprüche 1 bis 3, **dadurch gekennzeichnet, dass** das Chipmodul mittels einer flächigen Abdeckung, die an der Gaze durch eine thermoplastische Verbindung befestigt ist, zwischen der Gaze und der flächigen Abdeckung fixiert ist.

5. Elastomerprodukt nach einem der Ansprüche 1 bis 4, **dadurch gekennzeichnet, dass** der Antennenleiter ein mechanisch verkürzter aber auf eine vorgegebene Resonanzfrequenz elektrisch verlängerter Dipol ist, der in einer Koppelzone zu einer der Form der Koppelschleife des Chipmoduls folgender Windung geformt ist und dessen Strahlerelemente sich in Strahlerzonen außerhalb der Koppelzone zunächst in gegensätzliche Richtung erstrecken und anschließend jeweils wenigstens einmal abknicken.

## Claims

1. Elastomer product comprising an electronic assembly embedded into an elastomeric material (24) and enclosed by the latter, said electronic assembly comprising a chip module composed of a first carrier with a chip containing an integrated electronic circuit, and also an antenna conductor (14, 32), **characterized in that** the electronic assembly furthermore comprises, as a further constituent of the chip module composed of the first carrier with the chip containing the integrated electronic circuit, an inductive coupling loop connected to the chip and an antenna module (10) composed of a second carrier and the antenna conductor wherein the chip module is arranged in or on the antenna module and the coupling loop is inductively coupled to the antenna conductor, the second carrier is a flexible sheetlike structure composed of gauze (12), the gauze comprises textile, electrically non-conductive threads or fibres (16, 18) arranged in the manner of a grid and containing thread- or fibre-free interspaces (20), and **in that** said interspaces are pervaded by the elastomeric material and interconnect the surfaces (28, 30) of the elastomeric material that adjoin the flat sides of the second carrier through the gauze.

2. Elastomer product according to Claim 1, **characterized in that** the antenna conductor comprises a flexible wire or textile, electrically conductive threads or fibres which are secured to the threads or fibres of the gauze by means of textile embroidery technology using electrically non-conductive textile embroidery yarn.

3. Elastomer product according to Claim 1, **characterized in that** the antenna conductor comprises a flexible wire or textile, electrically conductive threads or fibres which are themselves further constituents of the gauze.

4. Elastomer product according to any of Claims 1 to 3, **characterized in that**, by means of a planar covering secured to the gauze by a thermoplastic bond, the chip module is fixed between the gauze and the planar covering.

5. Elastomer product according to any of Claims 1 to 4, **characterized in that** the antenna conductor is a dipole which is mechanically shortened but electrically lengthened to a predefined resonant frequency and which is shaped in a coupling zone to form a winding following the shape of the coupling loop of the chip module and the radiator elements of which extend in radiator zones outside the coupling zone initially in opposite directions and then each bend away at least once.

## Revendications

1. Produit élastomère comprenant un sous-ensemble électronique enrobé dans un matériau élastomère (24) et encapsulé par celui-ci, lequel comporte un module à puce composé d'un premier élément porteur comprenant une puce qui contient un circuit électronique intégré, ainsi qu'un conducteur d'antenne (14, 32), **caractérisé en ce que** le sous-ensemble électronique comporte, en tant qu'élément constitutif supplémentaire du module à puce composé du premier élément porteur comprenant la puce qui contient le circuit électronique intégré, en plus d'une boucle de couplage inductive reliée à la puce et un module d'antenne (10) composé d'un deuxième élément porteur et du conducteur d'antenne, le module à puce étant disposé dans ou sur le module d'antenne et la boucle de couplage étant couplée inductivement avec le conducteur d'antenne, le deuxième élément porteur étant un objet plat flexible en gaze (12), la gaze comprenant des fils ou des fibres textiles (16, 18) non électriquement conducteurs qui sont disposés à la manière d'un treillis et contiennent des espaces intermédiaires (20) exempts de fils ou de fibres, et **en ce que** ces espaces intermédiaires sont entrecoupés par le matériau élastomère et relient entre elles à travers la gaze les surfaces (28, 30) du matériau élastomère adjacentes des côtés plats du deuxième élément porteur.

2. Produit élastomère selon la revendication 1, **caractérisé en ce que** le conducteur d'antenne comporte un brin flexible ou des fils ou des fibres textiles non électriquement conducteurs qui sont fixés aux fils ou aux fibres de la gaze au moyen de fils à broder textiles non électriquement conducteurs par technique de broderie textile.

3. Produit élastomère selon la revendication 1, **caractérisé en ce que** le conducteur d'antenne comporte un brin flexible ou des fils ou des fibres textiles non électriquement conducteurs qui sont des éléments constitutifs supplémentaires de la gaze elle-même.

4. Produit élastomère selon l'une des revendications 1 à 3, **caractérisé en ce que** le module à puce est fixé entre la gaze et un revêtement protecteur plat au moyen du revêtement protecteur qui est fixé à la gaze par une liaison thermoplastique.

5. Produit élastomère selon l'une des revendications 1 à 4, **caractérisé en ce que** le conducteur d'antenne est un dipôle mécaniquement raccourci, mais prolongé électriquement à une fréquence de résonance prédéfinie, lequel est façonné dans une zone de couplage en une spire qui suit la forme de la boucle de couplage du module à puce et dont les éléments rayonnants s'étendent tout d'abord dans une direction opposée dans des zones d'élément rayonnant à l'extérieur de la zone de couplage et ensuite se plient respectivement au moins une fois.
